# EUROPÄISCHE PATENTSCHRIFT

(11) **EP 0 611 273 B1**
(45) Veröffentlichungstag und Bekanntmachung des Hinweises auf die Patenterteilung: **16.09.1998**
(21) Anmeldenummer: 94890002.2
(22) Anmeldetag: 03.01.1994
(51) Int. Cl.: H01L 21/00

(54) **Träger für scheibenförmige Gegenstände**
Holder for disc-like articles
Support pour objets en forme de disque

(30) Priorität: 08.02.1993 AT 221/93
(43) Veröffentlichungstag der Anmeldung: 17.08.1994
(73) Patentinhaber: SEZ Semiconductor-Equipment Zubehör für die Halbleiterfertigung AG, 9500 Villach (AT)
(72) Erfinder: Sumnitsch, Franz, A-9020 Klagenfurt, Kärnten (AT)
(74) Vertreter: Beer, Manfred, Dipl.-Ing.

(56) Entgegenhaltungen:
- EP-A- 0 048 995
- EP-A- 0 456 426
- FR-A- 2 566 682

## Beschreibung

Die Erfindung betrifft einen Träger mit den Merkmalen des einleitenden Teils des unabhängigen Anspruches 1. Derartige Träger werden insbesondere als Träger für Siliziumscheiben während des Ätzens derselben verwendet und besitzen eine für gewöhnlich ringförmige Düse in der dem Gegenstand zugekehrten, kreisrunden Fläche.

Ein Träger der oben umschriebenen Gattung ist aus der US-A-4 445 494 bekannt. Bei diesem bekannten Träger ist in der dem scheibenförmigen Gegenstand zugekehrten Fläche des Trägers in der Mitte des Trägers eine Kugel eingesetzt, so daß der scheibenförmige Gegenstand nur punktförmig abgestützt wird. Der aus der US-A-4 445 494 bekannte Träger dient dazu, scheibenförmige Gegenstände abzustützen, während sie von einem Stab abgesägt werden, und dazu die vom Stab abgeschnittene Scheibe abzuschwenken und einer Sammelvorrichtung zu übergeben. Eine Behandlung bzw. Weiterbearbeitung des scheibenförmigen Gegenstandes, während er vom Träger gehalten wird, ist in der US-A-4 445 494 nicht vorgesehen. Es ist auch nicht möglich, den Gegenstand durch den Träger der US-A-4 445 494 in Drehung zu versetzen, da die Kugel des Trägers nur im Bereich des Zentrums des Gegenstandes angreift, so daß auf diesen keine Drehmomente übertragen werden können.

Träger für scheibenförmige Gegenstände sind auch aus der US-A-4 903 717 bekannt. Diese besitzen in der dem scheibenförmigen Gegenstand zugekehrten Fläche keine Abstützung, so daß der scheibenförmige Gegenstand am Träger ausschließlich durch das Bernoulli-Prinzip auf einem sich zwischen dem scheibenförmigen Gegenstand und dem Träger ausbildenden Gaspolster festgehalten wird.

Eine Schwierigkeit bei diesen bekannten Trägern besteht darin, daß die scheibenförmigen Gegenstände auf dem Gaspolster praktisch schwimmen und daher nach der Seite hin nicht festgelegt sind. Es sind daher bei dem aus der US-A-4 903 717 bekannten Träger an den Rand des scheibenförmigen Gegenstandes anlegbare Haltenocken vorgesehen.

Diese Haltenocken haben aber den Nachteil, daß sie zur Anpassung an verschiedene Durchmesser radial verstellbar sein müssen und daß sie beim Behandeln des scheibenförmigen Gegenstandes mit einer Behandlungsflüssigkeit, insbesondere beim Ätzen von Siliziumscheiben, die Strömung der Behandlungsflüssigkeit im Randbereich beeinflussen, so daß sich dort eine ungleichmäßige Ätzung bzw. Behandlungswirkung ergeben kann.

Aus der EP-A-456 426 und der FR-A-2 566 682 sind Träger bekannt, die scheibenförmige Gegenstände durch Anlegen von Unterdruck festhalten. Hierzu ist bei dem Träger der EP-A-456 426 in der Mitte des starr ausgebildeten Trägers eine zu einer Unterdruckquelle führende Leitung vorgesehen. Die über Vorsprünge des bekannten Trägers gesteckten elastischen Ringe bzw. Hülsen haben nur die Funktion, den scheibenförmigen Gegenstand abzustützen, bevor Vakuum angelegt wird. Sobald über die Leitung Vakuum angelegt worden ist, werden die elastischen Hülsen verformt, bis der scheibenförmige Gegenstand mit seinem äußeren Rand an einer Ringleiste des Trägers anliegt.

Bei der FR-A-2 566 682 ist in der Mitte des Trägers ebenfalls eine Leitung vorgesehen, über die Vakuum angelegt werden kann und deren Mündung über die dem zu haltenden Gegenstand zugekehrte Fläche des Trägers vorsteht. Im Bereich der Mündung der Leitung ist in einer Ringnut eine Ringdichtung aufgenommen, damit Vakuum wirksam angelegt werden kann. Der Gegenstand wird außerdem nach dem Bernouilliprinzip unter Verwendung von Wasser festgehalten.

Der Erfindung liegt die Aufgabe zugrunde, ausgehend von der US-A-4 445 494 den bekannten Träger so zu verbessern, daß ein sicheres Halten von scheibenförmigen Gegenständen möglich ist, während sie mit Behandlungsflüssigkeit behandelt werden, ohne daß an den Rand des scheibenförmigen Gegenstandes anliegende Haltenocken erforderlich sind.

Erfindungsgemäß wird diese Aufgabe mit den Merkmalen des kennzeichnenden Teils des unabhängigen Anspruches 1 gelöst.

Bei dem erfindungsgemäßen Träger wird der scheibenförmige Gegenstand von dem auf Grund des aerodynamischen Paradoxons (Bernoulli-Prinzip) entstehenden Unterdruck zwischen dem scheibenförmigen Gegenstand und der ihm zugekehrten Fläche des Trägers gegen den Vorsprung gedrückt. Da der Vorsprung (oder die Vorsprünge) bei der Erfindung am Gegenstand (wenigstens) außerhalb dessen Mitte angreifen, können sie den Gegenstand während dem Behandeln sicher halten (keine Gefahr des Kippens) und der Gegenstand kann durch Drehen des Trägers in Drehung versetzt werden, da der Vorsprung bzw. die Vorsprünge am Gegenstand außermittig angreifen und daher auf den Gegenstand Drehmomente übertragen werden können.

In einer Ausführungsform der Erfindung ist vorgesehen, der Vorsprung eine Platte aus Keramik oder Kunststoff ist.

Eine vorteilhafte Ausführungsform der Erfindung sieht vor, daß der Vorsprung in einer Richtung senkrecht zu der dem Gegenstand zugekehrten Fläche des Trägers elastisch nachgiebig ist. Bei dieser Ausführungsform gibt der Vorsprung elastisch in Richtung auf die dem scheibenförmigen Gegenstand zugekehrte Fläche des Trägers hin nach, so daß sich ein Gleichgewichtszustand ergibt, der Verformungen des scheibenförmigen Gegenstandes, wie sie bei einem starren, nur in der Mitte des Gegenstandes anliegenden Vorsprung gemäß der US-A-4 445 494 auftreten können, wenn dieser nicht richtig dimensioniert ist, ausschließt. Dennoch wird der scheibenförmige Gegenstand durch Reibschluß auch in Richtung parallel zu der dem Gegenstand zugekehrten Fläche des Trägers so sicher festgehalten, daß er mit einer Behandlungsflüssigkeit behandelt und zum Abschleudern derselben durch Drehen des Trägers in Drehung versetzt werden kann.

Eine vorteilhafte Ausführungsform der Erfindung ist dadurch gekennzeichnet, daß der Vorsprung konzentrisch zur Achse des Trägers angeordnet ist. So wird ein gleichmäßiged Verteilen der auf den vom Träger gehaltenen, scheibenförmigen Gegenstand einwirkenden Kräfte gewährleistet.

Eine besonders einfache Ausführungsform mit einem elastisch nachgiebiggen Vorsprung ergibt sich, wenn vorgesehen ist, der Vorsprung eine in die dem Gegenstand zugekehrte Fläche des Trägers eingelassene Platte aus elastisch nachgiebigem Werkstoff ist.

Bevorzugt ist es im Rahmen der Erfindung, wenn die Platte eine Platte aus porösem Kunststoff oder poröser Keramik ist. Bei dieser Ausführungsform kann sich der den Gegenstand am Träger haltende Unterdruck auch innerhalb bzw. im Bereich des Vorsprunges ausbilden, so daß die Haltekraft erhöht wird.

Wenn der Vorsprung aus einem starren Werkstoff besteht, ist bei der Erfindung eine Ausführungsform bevorzugt, bei welcher die Platte gegenüber dem Träger durch elastische Elemente abgestützt ist. Die elastischen Elemente können Schraubenfedern sein.

Eine praktische Ausführungsform der Erfindung ist dadurch gekennzeichnet, daß der Vorsprung in der dem Gegenstand zugekehrten Fläche des Trägers ein in die dem Gegenstand zugekehrte Fläche des Trägers eingesetzter Ring aus elastisch nachgiebigem Werkstoff ist. Bei dieser Ausführungsform ist es erfindungsgemäß bevorzugt, wenn der Ring aus elastisch nachgiebigem Werkstoff in eine kreisringförmige Nut in der den Gegenstand zugekehrten Fläche des Trägers eingesetzt ist, und/oder wenn der ringförmige Vorsprung aus mit Teflon ummanteltem Silikon besteht. Auch bei dieser Ausführungsform kann vorgesehen sein, daß der Ring aus porösem Kunststoff besteht oder hohl ist, so daß sich der oben für poröse Vorsprünge geschilderte vorteilhafte Effekt ergibt.

Eine andere Ausführungsform des erfindungsgemäßen Trägers ist dadurch ausgezeichnet, daß in der dem Gegenstand zugekehrten Fläche des Trägers mehrere Vorsprünge in einer zum Außenumfang des Trägers parallelen Reihe, bei einem kreisrunden Träger im Kreis herum angeordnet sind. Die Vorsprünge können am elastischen Werkstoff bestehen oder es ist - wenn elastisch nachgiebige Vorsprünge gewünscht sind - vorgesehen, daß jeder Vorsprung gegenüber dem Träger durch ein elastisches Element abgestützt ist. Das elastische Element kann eine Schraubenfeder sein.

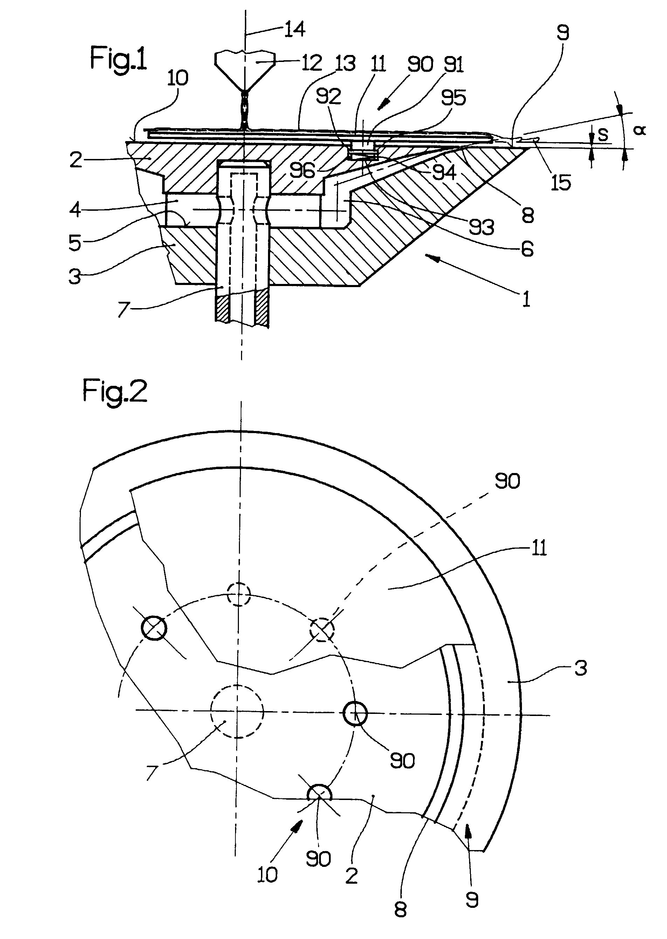

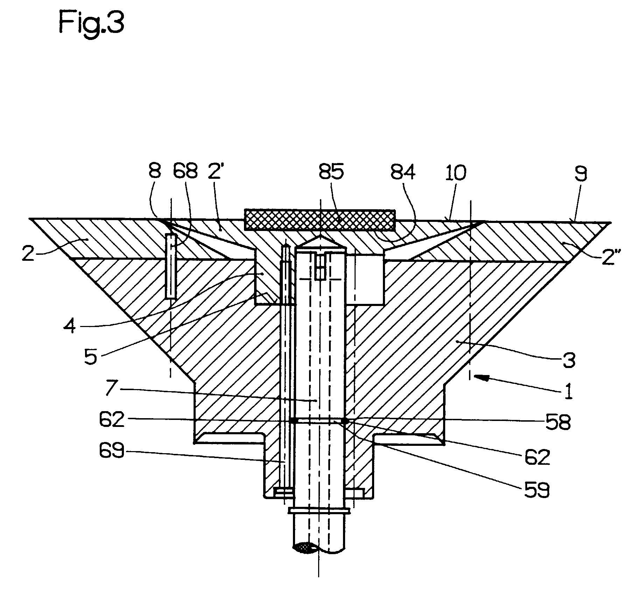

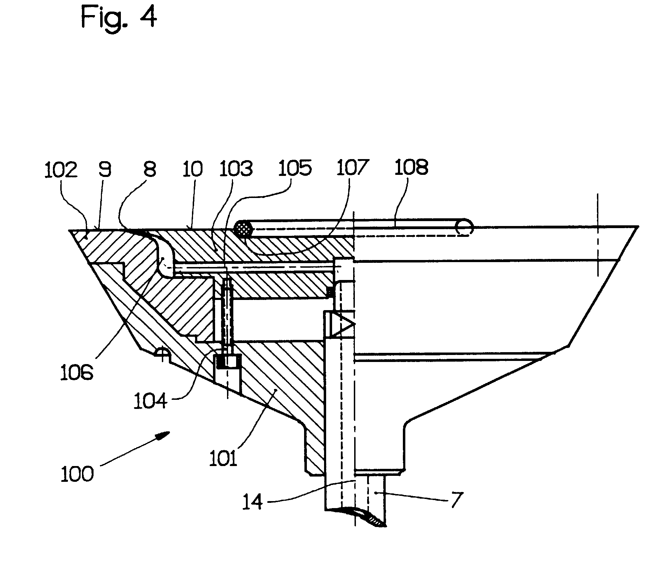

Weitere Einzelheiten und Merkmale der Erfindung ergeben sich aus der nachstehenden Beschreibung der in den Zeichnungen dargestellten Ausführungsformen von Trägern gemäß der Erfindung. Es zeigt: Fig. 1 eine erste Ausführungsform im Axialschnitt, Fig. 2 eine Draufsicht auf die Ausführunsform von Fig. 1, Fig. 3 eine weitere Ausführungsform eines Trägers im Axialschnitt und Fig. 4 eine vierte Ausführungsform, ebenfalls im Axialschnitt.

Ein in Fig. 1 gezeigter Träger 1 ist rotationssymmetrisch ausgebildet und besteht aus einem inneren, vorzugsweise aus Metall gefertigten Teil 2 und einem äußeren, etwa topfförmigen, vorzugsweise aus Kunststoff bestehenden Teil 3. Der innere Teil 2 sitzt mit einem Ansatz 4 auf einer nach oben gerichteten Fläche 5 des äußeren Teils 3 auf, so daß die Relativlage der Teile 2 und 3 zueinander definiert ist.

Zwischen den beiden Teilen 2 und 3 des Trägers 1 ist ein Raum 6 vorgesehen, in den über eine hohl ausgebildete Welle 7 unter Druck stehendes Gas, wie beispielsweise Luft oder Stickstoff, eingeführt werden kann. Der Raum 6 mündet in eine Ringdüse 8 aus, deren von den Teilen 2 und 3 gebildete Begrenzungswände mit der oberen Fläche des Trägers 1 einen spitzen Winkel a einschließen.

An Stelle der Düse 8 in Form eines ringförmigen Schlitzes können bei allen beschriebenen Ausführungsformen mehrere, beispielsweise längs eines zur Achse 14 des Trägers konzentrischen Kreises angeordnete, Düsen vorgesehen sein. Diese Düsen können lochartige (runde) Austrittsöffnungen oder schlitzförmige Austrittsöffnungen, die nach einem Kreisbogen gekrümmt sein können, sein.

Die obere Endfläche des Trägers 1 wird von einer Kreisringfläche 9 des Teils 3 und einer Kreisfläche 10 des Teils 2 gebildet. Zwischen der Kreisringfläche 9 und der Kreisfläche 10 mündet die Ringdüse 8 in der Endfläche des Trägers 1 aus.

Ein scheibenförmiger Gegenstand 11 wird durch das über die Hohlwelle 7 zugeführte und aus der Düse 8 austretende Gas von der ihm zugekehrten Fläche des Trägers 1 (Kreisringfläche 9 und Kreisfläche 10) im Abstand S gehalten. Durch die besondere Ausbildung der Ringdüse 8 ergibt sich beim Ausströmen des Gases zwischen der dem Gegenstand 11 zugekehrten Fläche 9, 10 des Trägers 1 und dem Gegenstand 11 ein Unterdruck (Bernoulli-Prinzip), durch den der scheibenförmige Gegenstand 11 nieder) gehalten und nicht vom aus der Ringdüse 8 ausströmenden Gas weggeblasen wird. Dabei ergibt sich bei der erfindungsgemäßen Ausführung des Trägers 1 der Vorteil, daß der Abstand S vom Druck des dem Raum 6 zugeführten und aus der Ringdüse 8 ausströmenden Gases weitgehend unabhängig ist.

In Fig. 1 ist gezeigt, daß über dem scheibenförmigen Gegenstand 11 eine Leitung 12 mündet, durch die der oberen Fläche des scheibenförmigen Gegenstandes 11 Behandlungsflüssigkeit, beispielsweise eine Säure zum Ätzen einer Siliziumscheibe zugeführt werden kann. In Fig. 1 ist auch gezeigt, daß die auf den scheibenförmigen Gegenstand 11 aufgebrachte Behandlungsflüssigkeit auf seiner Oberseite einen Flüssigkeitsfilm 13 bildet, dessen Dicke und Gleichmäßigkeit über die gesamte Fläche von der aufgebrachten Menge an Behandlungsflüssigkeit und der Drehzahl des Trägers 1 um seine Achse 14 abhängt. Der Film 13 aus Behandlungsflüssigkeit reißt an der Außenkante des scheibenförmigen Gegenstandes 11 ab. Die dabei entstehenden Tröpfchen 15 werden, wie in Fig. 1 angedeutet, vom aus der Ringdüse 8 ausströmenden Gas weggeblasen, so daß Behandlungsflüssigkeit nicht auf die untere Seite des scheibenförmigen Gegenstandes 11 gelangt.

In der Fläche 10 des Teils 2 sind entlang eines zur Achse 14 des Trägers 1 konzentrischen Kreises angeordnet Vorsprünge 90 vorgesehen. Die Vorsprünge 90 werden von zylinderförmigen Körpern 91 gebildet, die in Sacklöcher 92 im Teil 20 des Trägers 1 in einer zur Achse 14 parallelen Richtung gleitend aufgenommen sind. Zwischen dem Boden 93 der Sacklöcher 90 und der zum Träger 1 hin gekehrten Endfläche der zylinderförmigen Körper 91 ist jeweils eine Schraubenfeder 94 vorgesehen, die den zylinderförmigen Körper 91 in Fig. 1 nach oben, d.h. auf den scheibenförmigen Gegenstand 11 zu drückt.

Um zu verhindern, daß die zylinderförmigen Körper 91 aus den Sacklöchern 92 zur Gänze heraustreten können, ohne daß dies gewünscht wird, können beispielsweise die zylinderförmigen Körper 91 mit den Schraubenfedern 94 und diese ihrerseits mit dem Boden 93 der Sacklöcher 92 verbunden sein. Alternativ ist es möglich, an den zylinderförmigen Körpern 91 seitlich wenigstens einen Vorsprung 95 anzubringen, der in eine Nut 96 in der Wand des Sackloches 92 eingreift, wobei eine bajonettverschlußartige Arretierung mit dem nötigen axialen Spiel für die erforderliche Beweglichkeit des zylinderförmigen Körpers 91 vorgesehen sein kann, d.h. der Vorsprung 95 des zylinderförmigen Körpers 91 besitzt in der Nut 96 in der Wand des Sackloches 92 das erforderliche axiale Spiel.

Bei der in Fig. 3 dargestellten Ausführungsform ist der Teil 2 des Trägers 1 aus einem Teil 2" und einem Teil 2' zusammengesetzt. Der Teil 2' bildet die Kreisfläche 10 und der Teil 2" die Kreisringfläche 9. Die Ringdüse 8 wird von den einander zugekehrten Flächen der Teile 2" und des Teils 2' gebildet.

Der Teil 2" wird durch zwei Paßstifte 68 und eine nicht näher dargestellte Schnappverbindung am äußeren Teil 3 befestigt.

Der Teil 2' sitzt mit einem Ansatz 4 auf einer nach oben gerichteten Fläche 5 des Teiles 3. Der Teil 2' und der äußere Teil 3 sind miteinander durch Schrauben 69 fest verbunden. Durch das Einfügen von Beilagscheiben zwischen den Ansatz 4 und die Fläche 5 des äußeren Teiles 3 kann die Relativlage des Teils 2' zum äußeren Teil 3 in axialer Richtung verändert werden, so daß die Breite der Ringdüse 8 auf die gewünschte Größe eingestellt werden kann.

Um die Hohlwelle 7 im äußeren Teil 3 in axialer Richtung festzulegen, sind in der Welle 7 eine Ringnut 59 und in der Bohrung für die Welle 7 im äußeren Teil 3 eine Ringnut 58 vorgesehen, die einander gegenüberliegen. Weiters sind im äußeren Teil 3 zwei zueinander parallele, durch den Teil 3 gehende Bohrungen vorgesehen, die zu beiden Seiten der Welle 7 liegen, mit ihren Mittelachsen die Welle 7 berühren und durch die Ringnuten 58 und 59 durchführen. In die Bohrungen sind Federstahlstifte 62 eingesetzt, die durch die Ringnuten 58, 59 ragen und somit die hohle Welle 7 in axialer Richtung am äußeren Teil 3 halten.

In der oberen Endfläche 10 des Teils 2', das ist die dem am Träger 1 zu haltenden, scheibenförmigen Gegenstand 11 zugekehrte Fläche, ist in einer Vertiefung 84 eine beispielsweise kreisrunde Platte 85 aus porösem Kunststoff (z.B. Polyvinylidenfluorid) eingesetzt. Diese Platte 85 aus porösem Kunststoff ist wenigstens in Richtung der Achse 14 elastisch nachgiebig, so daß sie beim Halten eines Gegenstandes 11 am Träger 1 unter der Wirkung des sich zwischen dem Träger 1 und der ihm zugekehrten Seite des scheibenförmigen Gegenstandes 11 ausbildenden Unterdrucks elastisch verformt, d.h. etwas elastisch zusammengedrückt wird. Es ist auch eine Ausführungsform mit einer Platte 85 aus starrem Kunststoff oder aus Keramik, die vorzugsweise porös ist, möglich.

Es ist noch darauf hinzuweisen, daß auch die den Vorsprung bildende Platte 85, ähnlich wie die zylinderförmigen Körper 9' der Ausführungsform von Fig. 1 und 2, an ihrer dem Träger zugekehrten Seite durch elastische Mittel, z.B. mehrere Schraubenfedern, elastisch abgestützt sein kann, d.h. sie muß nicht unmittelbar auf dem Boden der flachen Ausnehmung 84 im Teil 2' des Trägers 1 von Fig. 3 aufliegen.

Bei der in Fig. 4 gezeigten Ausführungsform besteht der eigentliche Träger 100 ebenfalls aus mehreren rotationssymmetrischen Teilen, nämlich einem unteren topfförmigen Teil 101, einem ringförmigen Teil 102 und einem plattenförmigen, runden Teil 103, der mit Hilfe von Schrauben 104 am topfförmigen Teil 101 festgelegt wird und dabei auch den ringförmigen Teil 102 festlegt. Zwischen dem ringförmigen Teil 102 und dem runden, plattenförmigen Teil 103 ist die Ringdüse 8 für den Austritt von Gas vorgesehen, das über die hohle Welle 7 und mehrere radiale Bohrungen 105 in einen Raum 106 zwischen dem ringförmigen Teil 102 und dem runden, plattenförmigen Teil 103 gebildet wird, zugeführt wird.

In der dem (in Fig. 4 nicht dargestellten) Gegenstand 11 zugekehrten Fläche 10 des kreisrunden, plattenförmigen Teils 103 ist eine kreisrunde Nut 107 vorgesehen, die im Querschnitt etwa halbkreisförmig ist. In diese Nut 107 ist ein Ring 108 eingesetzt, der beispielsweise aus Silikon besteht und daher elastisch nachgiebig ist. Der Ring 108 aus Silikon kann an seiner Außenfläche mit Teflon beschichtet sein. Der Ring 108 kann ein Ring 108 aus Vollmaterial sein, oder aus porösem Werkstoff, z.B. dem oben für die Platte 85 erwähnten Werkstoff, bestehen, oder ein hohler Ring sein. In einer Ausführungsform ist der Ring 108 in Richtung der Achse 14 elastisch.

Der Ring 108 wird ähnlich wie der elastische Körper 85 der Ausführungsform von Fig. 3 unter der Wirkung des Unterdruckes zwischen den scheibenförmigen Gegenstand 11 und der diesem zugekehrten Fläche des Trägers 100 elastisch zusammengedrückt, so daß der scheibenförmige Gegenstand 11 sicher am Träger 100 gehalten wird und sich auch seitlich nicht bewegen kann.

Wenn der Vorsprung (insbesondere die Platte oder der Ring) des erfindungsgemäßen Trägers aus porösem Werkstoff besteht, dann ergibt sich bei Betrieb der Vorrichtung der Vorteil, daß sich der auf Grund der Bernoulli-Prinzips ausbildende Unterdruck auch in dem Bereich ausbildet, in dem der scheibenförmige Gegenstand am Vorsprung anliegt, so daß dessen Halt am Träger noch verbessert wird.

In einem Träger 100 für einen scheibenförmigen Gegenstand ist in der dem scheibenförmigen Gegenstand zugekehrten Fläche 9, 10 eine Düse 8 vorgesehen, aus welcher Gas austritt und den scheibenförmigen Gegenstand durch den aufgrund des Bernoulli-Prinzips entstehenden Unterdruck gegen einen in der dem Gegenstand zugekehrten Fläche 10 vorgesehenen, kreisringförmigen Vorsprung 108 hält. Der Vorsprung 108 ist in Richtung der Achse 14 des Trägers 100, d.h. senkrecht zu der dem Gegenstand zugekehrten Fläche 10 des Trägers 100 elastisch nachgiebig, so daß der Gegenstand gegen Verschieben in einer zur Fläche 10 parallelen Richtung sicher am Träger 100 gehalten wird, ohne daß es erforderlich ist, seitliche Abstützungen, wie Nocken od. dgl. vorzusehen. Dadurch, daß seitliche Abstützungen entbehrlich sind, behindern diese auch nicht das Abströmen von Behandlungsflüssigkeit vom Rand des Gegenstandes, der an dem Träger 100 festgehalten ist.

## Patentansprüche

1. Träger (1, 100) nach dem Bernoulliprinzip für scheibenförmige Gegenstände (11) mit einer Düse (8), in der dem Gegenstand (11) zugekehrten Fläche (9, 10) des Trägers (1, 100), die eine durch das Zentrum der genannten Fläche (9, 10) verlaufende und auf die Fläche (9, 10) senkrecht stehende Achse (14) umgibt und der zum Ausbilden eines Gaspolsters zwischen dem Träger (1) und dem scheibenförmigen Gegenstand (11) Druckgas zuführbar ist, und mit wenigstens einem Vorsprung (85, 90, 108) in der genannten, dem Gegenstand (11) zugekehrten Fläche (9, 10) des Trägers (1, 100) als Auflage für den Gegenstand, wobei der Vorsprung (85, 90, 108) innerhalb des von der Düse (8) umfaßten Bereiches der dem Gegenstand (11) zugekehrten Fläche (9, 10) des Trägers (1, 100) angeordnet ist, dadurch gekennzeichnet, daß der Träger als um die genannte Achse (14) drehbar ausgebildet ist, und daß der Vorsprung (85, 90, 108) wenigstens bereichsweise in radialem Abstand von der Achse (14) des Trägers (1, 100) jedoch radial innerhalb der Düse (8) vorgesehen ist und dort eine Auflage für den Gegenstand (11) bildet.

2. Träger nach Anspruch 1, dadurch gekennzeichnet, daß der Vorsprung eine Platte aus Keramik oder Kunststoff ist.

3. Träger nach Anspruch 1 oder 2, dadurch gekennzeichnet, daß der Vorsprung (85, 90, 108) in einer Richtung senkrecht zu der dem Gegenstand (11) zugekehrten Fläche (9, 10) des Trägers (1, 100) elastisch nachgiebig ist.

4. Träger nach Anspruch 1 oder 3, dadurch gekennzeichnet, daß der Vorsprung konzentrisch zur Achse (14) des Trägers (1, 100) angeordnet ist.

5. Träger nach Anspruch 3 oder 4, dadurch gekennzeichnet, daß der Vorsprung (85) eine in die dem Gegenstand (11) zugekehrte Fläche (9, 10) des Trägers (1) eingelassene Platte (85) aus elastisch nachgiebigem Werkstoff ist.

6. Träger nach einem der Ansprüche 2 bis 5, dadurch gekennzeichnet, daß die Platte (85) eine Platte (85) aus porösem Kunststoff oder poröser Keramik ist.

7. Träger nach einem der Ansprüche 2 bis 6, dadurch gekennzeichnet, daß die Platte (85) gegenüber dem Träger (1) durch elastische Elemente abgestützt ist.

8. Träger nach Anspruch 7, dadurch gekennzeichnet, daß die elastischen Elemente Schraubenfedern (94) sind.

9. Träger nach Anspruch 3 oder 4, dadurch gekennzeichnet, daß der Vorsprung in der dem Gegenstand (11) zugekehrten Fläche (9, 10) des Trägers (100) ein in die dem Gegenstand (11) zugekehrte Fläche (9, 10) des Trägers (100) eingesetzter Ring (108) aus elastisch nachgiebigem Werkstoff ist.

10. Träger nach Anspruch 9, dadurch gekennzeichnet, daß der Ring (108) aus elastisch nachgiebigem Werkstoff in eine kreisringförmige Nut (107) in der den Gegenstand (11) zugekehrten Fläche (10) des Trägers (100) eingesetzt ist.

11. Träger nach Anspruch 9 oder 10, dadurch gekennzeichnet, daß der Ring (108) aus mit Teflon ummanteltem Silikon besteht.

12. Träger nach einem der Ansprüche 9 oder 10, dadurch gekennzeichnet, daß der Ring (108) aus porösem Kunststoff besteht oder hohl ist.

13. Träger nach Anspruch 1, dadurch gekennzeichnet, daß in der dem Gegenstand (11) zugekehrten Fläche (10) des Trägers (1) mehrere Vorsprünge (90) in einer zum Außenumfang des Trägers (1) parallelen Reihe, bei einem kreisrunden Träger (1) im Kreis herum angeordnet sind.

14. Träger nach Anspruch 13, dadurch gekennzeichnet, daß jeder Vorsprung (90) gegenüber dem Träger (1) durch ein elastisches Element (94) abgestützt ist.

15. Träger nach Anspruch 14, dadurch gekennzeichnet, daß das elastische Element eine Schraubenfeder (94) ist.

## Claims

1. A holder (1, 100) for disc-shaped articles (11) based on the Bernoulli principle, with a nozzle (8) in the surface (9, 10) ofthe holder (1, 100) facing the article (11), surrounding an axis (14) through the centre of the said surface (9, 10) and perpendicular to the surface (9, 10), and to which gas under pressure can be fed to form a gas cushion between the holder (1) and the disc-shaped article (11), and with at least one projection (85, 90, 108) in the said surface (9, 10) of the holder (1, 100) facing the article (11), as a support pad for the article, wherein the projection (85, 90, 108) is disposed within the region of the surface (9, 10) of the holder (1, 100) facing the article (11) which is surrounded by the nozzle (8), characterized in that the holder is rotatable about the said axis (14) and in that the projection (85, 90, 108) is provided at least regionally at a radial distance from the axis (14) of the holder (1, 100) but radially inside the nozzle (8) and there forms a support pad for the article (11).

2. A holder according to claim 1, characterized in that the projection is a plate of ceramic or plastics material.

3. A holder according to claim 1 or 2, characterized in that the projection (85, 90, 108) is elastically yielding in a direction perpendicular to the surface (9, 10) of the holder (1, 100) facing the article (11).

4. A holder according to claim 1 or 3, characterized in that the projection is concentric with the axis (14) ofthe holder (1, 100).

5. A holder according to claim 3 or 4, characterized in that the projection (85) is a plate of elastically yielding material sunk into the surface (9, 10) of the holder (1) facing the article (11).

6. A holder according to any of claims 2 to 5, characterized in that the plate (85) is a plate (85) of porous plastics material or porous ceramic.

7. A holder according to any of claims 2 to 6, characterized in that the plate (85) is supported relative to the holder (1) by elastic elements.

8. A holder according to claim 7, characterized in that the elastic elements are helical springs (94).

9. A holder according to claim 3 or 4, characterized in that the projection in the surface (9, 10) of the holder (100) facing the article (11) is a ring (108) of elastically yielding material fitted in the surface (9, 10) of the holder (100) facing the article (11).

10. A holder according to claim 9, charactenzed in that the ring (108) of elastically yielding material is fitted in a circular groove (107) in the surface (10) of the holder (100) facing the article (11)

11. A holder according to claim 9 or 10, charactenzed in that the ring (108) consists of silicone coated with Teflon.

12. A holder according to claim 9 or 10, charactenzed in that the ring (108) consists of porous plastics material or is hollow.

13. A holder according to claim 1, characterized in that several projections (90) are arranged in a row parallel to the outer periphery of the holder (1) ) in the surface (10) of the holder (1) ) facing the article (11), in a circle in the case of a circular holder (1),

14. A holder according to claim 13, characterized in that each projection (90) is supported relative to the holder (1) by an elastic element (94).

15. A holder according to claim 14, characterized in that the elastic element is a helical spring (94).

## Revendications

1. Support (1,100) selon le principe Bernouilli pour des objets (11) en forme de plaquettes, avec une buse (8) dans la surface (9, 10) du support (1, 10) tournée vers l'objet (11), qui entoure un axe (14) passant par le centre de ladite surface (9, 10) et perpendiculaire à la surface (9, 10), à laquelle un gaz sous pression peut être envoyé pour former un coussin de gaz entre le support (1) et l'objet (11) en forme de disque, et avec au moins une surélévation (85, 90 108) dans ladite surface (9, 10) du support (1, 100) tournée vers vers l'objet (11) servant d'appui à l'objet, la surélévation (85, 90, 108) étant disposée à l'intérieur de la zone de la surface (9, 10) du support (1, 100) tournée vers l'objet (11) entourée par la buse (8), caractérisé par le fait que le support est réalisé tournant autour de l'axe (14) mentionné, et que la surélévation (85, 90, 108), au moins par endroits est prévue à distance radiale de l'axe (14) du support (1, 100), mais radialement à l'intérieur de la buse (8) et forme un appui pour l'objet (11).

2. Support selon la revendication 1, caractérisé par le fait que la surélévation est une plaque en céramique ou en matière plastique.

3. Support selon la revendication 1 ou 2, caractérisé par le fait que la surélévation (85, 90, 108) dans une direction perpendiculaire à la surface du support (1, 100) tournée vers l'objet (11) est déformable élastiquement.

4. Support selon la revendication 1 ou 3, caractérisé par le fait que la surélévation est concentrique à l'axe (14) du support (1, 100).

5. Support selon la revendication 3 ou 4, caractérisé par le fait que la surélévation (85) est une plaque (85) en un matériau déformable élastiquement insérée dans la surface (9, 10) du support (1) tournée vers l'objet (11).

6. Support selon une des revendications 2 à 5, caractérisé par le fait que la plaque (85) est une plaque en matière plastique poreuse ou en céramique poreuse.

7. Support selon une des revendications 2 à 6, caractérisé par le fait que la plaque (85) est supportée par des éléments élastiques par rapporl au support (1).

8. Support selon la revendication 7, caractérisé par le fait que les éléments élastiques sont des ressorts hélicoïdaux (94).

9. Support selon la revendication 3 ou 4, caractérisé par le fait que la surélévation dans la surface (9, 10) du support (100) tournée vers l'objet (11) est un anneau (108) en matériau déformable élastiquement inséré dans la surface (9, 10) du support (100) tournée vers l'objet (11).

10. Support selon la revendication 9, caractérisé par le fait que l'anneau (108) en matériau déformable élastiquement est monté dans une gorge (107) annulaire aménagée dans la surface (10) du support (100) tournée vers l'objet (11).

11. Support selon la revendication 9 ou 10, caractérisé par le fait que l'anneau (108) est en silicone enrobé de téflon.

12. Support selon la revendication 9 ou 10, caractérisé par le fait que l'anneau (108) est en matériau poreux ou est creux.

13. Support selon la revendication 1, caractérisé par le fait que plusieurs surélévations (90) sont disposées en une rangée parallèle au pourtour du support (1), en cercle dans le cas d'un support (1) circulaire, dans la surface (10) du support (1) tournée vers l'objet (11).

14. Support selon la revendication 13, caractérisé par le fait que chaque surélévation (90) est supportée par un élément élastique (94) par rapport au support (1).

15. Support selon la revendication 14, caractérisé par le fait que l'élément élastique est un ressort hélicoïdal (94).
